# EUROPÄISCHE PATENTSCHRIFT

(11) **EP 2 274 366 B1**
(45) Veröffentlichungstag und Bekanntmachung des Hinweises auf die Patenterteilung: **05.12.2012**
(21) Anmeldenummer: 09742146.5
(22) Anmeldetag: 08.05.2009
(51) Int. Cl.: C08K 5/11, C08J 5/18

(54) **WEICHMACHERHALTIGE FOLIEN AUS POLYVINYLACETAL MIT CYCLOHEXAN-1,2-DICARBON-SÄUREESTERN ALS WEICHMACHER**
FILMS MADE OF POLYVINYL ACETAL CONTAINING PLASTICIZERS, SAID FILMS COMPRISING CYCLOHEXANE-1,2-DICARBOXYLIC ACID ESTERS AS PLASTICIZERS
FILMS PLASTIFIÉS À BASE D ACÉTAL DE POLYVINYLE AVEC DES ESTERS D ACIDE CYCLOHEXANE-1,2-DICARBOXYLIQUE COMME PLASTIFIANT

(30) Priorität: 08.05.2008 DE 102008001655
(43) Veröffentlichungstag der Anmeldung: 19.01.2011
(73) Patentinhaber: Kuraray Europe GmbH, 65795 Hattersheim (DE)
(72) Erfinder: KELLER, Uwe, 53177 Bonn (DE)
(86) Internationale Anmeldenummer: PCT/EP2009/055577
(87) Internationale Veröffentlichungsnummer: WO 2009/135928

(56) Entgegenhaltungen:
- WO-A1-97/24230
- WO-A2-2009/047223
- DE-A1- 10 116 812
- DE-A1- 10 343 385
- DE-A1-102004 043 907
- DE-A1-102005 028 752
- DE-U1-202006 014 595
- US-A1- 2004 015 007
- US-A1- 2005 131 133
- FERNANDEZ M D; FERNANDEZ M J; HOCES P: "Synthesis of poly(vinyl butyral)s in homogeneous phase and their thermal properties" JOURNAL OF APPLIED POLYMER SCIENCE, Bd. 102, 5. Dezember 2006 (2006-12-05), Seiten 5007-5017, XP002543320
- DATABASE WPI Week 199617 Thomson Scientific, London, GB; AN 1996-167134 XP002543321 & JP 08 048547 A (SEKISUI CHEM IND CO LTD) 20. Februar 1996 (1996-02-20)

## Beschreibung

Weichmacherhaltige Folien aus Polyvinylacetal mit Cyclohexan-1,2-dicarbon-säureestern als Weichmacher

### Technisches Gebiet

Die Erfindung betrifft eine als Zwischenschicht in Verbundsicherheitsgläsern geeignete weichmacherhaltige Folie auf der Basis von teilacetalisierten Polyvinylalkoholen, unter Verwendung von hydrierten Phthalatestern als Weichmacher sowie die Verwendung der Zwischenschichten in Verbundglaslaminaten und Photovoltaikmodulen.

### Stand der Technik

Verbundsicherheitsgläser bestehen im Allgemeinen aus zwei Glasscheiben und einer die Glasscheiben verbindenden Zwischenfolie. Als Folienmaterial wird überwiegend weichmacher-haltiger teilacetalisierter Poly-vinyl-alkohol (Polyvinylacetal), insbesondere Polyvinylbutyral (PVB) verwendet. Verbundsicherheitsgläser (VSG) werden beispielsweise als Windschutzscheiben oder Seitenverglasungen im Kraftfahrzeugbereich sowie als Sicherheitsverglasung im Baubereich eingesetzt.

Als Weichmacher für solche PVB-Folien sind mittlerweile aliphatische Diester des Tri- bzw. Tetraethylenglykols etabliert. Besonders häufig werden als Weichmacher 3G7, 3G8 oder 4G7 eingesetzt, worin die erste Ziffer die Anzahl der Ethlenglycoleinheiten und die letzte Ziffer die Anzahl der Kohlenstoffatome im Carbonsäureteil der Verbindung bezeichnet. So steht 3G8 für Triethylenglykol-bis-(2-ethylhexanoat), d.h. für eine Verbindung der Formel C₄H₉CH(CH₂CH₃)CO(OCH₂CH₂)₃O₂CCH(CH₂CH₃ )C₄H₉.

Als Weichmacher für teilacetalisierte Poly-vinyl-alkohole werden bevorzugt Verbindungen eingesetzt, die in einer VSG-Zwischen-schichtfolie für hohe Transparenz, niedrige Feuchtigkeits-aufnahme, gute Haftung zum Glas und eine ausreichende Kälteflexibilität der Folie sorgen. Weiterhin müssen diese Verbindungen eine ausreichende Verträglichkeit mit dem teilacetalisierten Poly-vinyl-alkohol aufweisen, d.h. in einer ausreichenden Menge ohne wieder auszuschwitzen mit diesem mischbar sein.

Allgemein sinkt die Verträglichkeit von Weichmacher und teilacetalisiertem Poly-vinyl-alkohol mit der Abnahme des polaren Charakters des Weichmachers. So sind Weichmacher höherer Polarität mit Polyvinylacetal besser verträglich als solche mit niedrigerer Polarität. Alternativ steigt die Verträglichkeit von Weichmachern geringer Polarität mit Zunahme des Acetalisierungsgrades, d.h. mit Abnahme der Anzahl an Hydroxygruppen und damit der Polarität des Polyvinylacetals.

In EP 0877 665 B1 wird das wenig polare 3G8 als Weichmacher für PVB-Folien empfohlen, weil es dem Folienprodukt eine verbesserte Feuchteresistenz verleiht. Da Feuchtigkeit die Haftung zwischen Klebfolie und Glas dauerhaft schädigen kann und im Extremfall zu sichtbaren Ablösungen der Folie vom Glas führt, wird bei der Herstellung von Verbundsicherheitsglas (VSG) mit PVB-Folie eine möglichst hohe Feuchteresistenz der Folie angestrebt.

Die verbesserte Feuchteresistenz von PVB-Folien, die mit 3G8 weichgemacht sind, ergibt sich aus dem stärker unpolaren Charakter dieses Weichmachers im Vergleich zu Weichmachern wie 4G7 oder 3G7, da anstelle eines Heptansäurerestes ein Octansäurerest das Weichmachermolekül chemisch konstituiert. Ein weiterer Vorteil bei der Verwendung von 3G8 ist dessen relativ geringe Flüchtigkeit, die zum einen einer Weichmacherverarmung an frei liegenden Kanten des VSG entgegenwirkt und zum anderen in einer nur geringen Geruchsbelästigung bei der Weiterverarbeitung der Folie zu VSG resultiert.

Aus diesen Gründen hat sich der Weichmacher 3G8 innerhalb kurzer Zeit bei den Herstellern von PVB-Folie etabliert.

Den hervorragenden technischen Eigenschaften dieses Produktes auf der einen Seite stehen jedoch erheblich höhere Beschaffungs- bzw. Produktionskosten im Vergleich zu in anderen Industriezweigen verbreiteten Standardweichmachern, etwa den zur Weichmachung von PVC verwendeten Phthalsäureestern, entgegen. Außerdem wäre eine weitere Reduktion der Feuchtaufnahme von weichgemachter PVB-Folie wünschenswert, da sich hiermit die Langlebigkeit von Verbundsicherheitsglas weiter erhöhen ließe. Durch den stark hydrophilen Triethylenglykolanteil sind im Falle des 3G8 einer weiteren Reduktion der Feuchteaufnahme aber Grenzen gesetzt.

Es ist aus EP 0 877 665 B1 bekannt, dass mit 3G8 nicht ohne weiteres PVB-Typen weichgemacht werden können, die einen Polyvinylalkoholgehalt größer 19,5 Gew.-% aufweisen, da dann ein Ausschwitzen des Weichmachers zu erwarten ist. Wie bei anderen weichmacherhaltigen Kunststoff-produkten ist das Ausschwitzen von Weichmachers auch bei Zwischenschichtfolien für VSG unerwünscht, da eine Abgabe des Weichmachers unter anderem entlang der freiliegenden Kante des PVB am Rand des Verbundes zu vorzeitiger Delamination führen kann. Auf Grund der geringen Verträglichkeit bzw. der Neigung von 3G8 zum Ausschwitzen ist in EP 0877 665 B1 der Einsatz von 3G8 auf PVB-Typen mit einem Polyvinylalkoholgehalt von 17 - 19,5 Gew.-% limitiert.

Im Prinzip betrifft die mangelnde Verträglichkeit von Weichmacher/PVB-Mischungen auch andere, unpolare Weichmacher wie z.B. Dialkyladipate mit mehr als 6 Kohlenstoffatomen im Esteralkohol, Dialkylsebazate mit mehr als 4 Kohlenstoffatomen im Esteralkohol oder Phthalatweichmacher wie Dioctylphthalat oder Di-isononylphthalat. Bei mangelnder Verträglichkeit beobachtet man auch hier ein Ausschwitzen des Weichmachers, insbesondere bei Lagerung in feuchter und/oder kalter Umgebung. Beide Umgebungsbedingungen kommen bei der Verwendung von PVB-Folie in der Praxis vor und sind somit für eine Bewertung der Weichmacherverträglichkeit relevant.

So werden PVB-Folienwickel zur Vermeidung von Verklebung benachbarter Folienlagen üblicherweise bei Temperaturen unterhalb von 8 °C gelagert und transportiert. Hier ist es natürlich unerwünscht, dass während der Lagerung flüssiger Weichmacher aus der Folie austritt.

Außerdem ist mit PVB-Folie gefertigtes Verbundsicherheitsglas im eingebautem Zustand abhängig von den klimatischen Bedingungen sowohl niedrigen Temperaturen als auch hoher Luftfeuchte ausgesetzt, was bei unzureichender Verträglichkeit insbesondere an den Kanten des VSG, an denen die PVB-Folie freiliegt, zu einem schleichendem Verlust des Weichmachers und damit die Entstehung von sichtbaren Defekten in Form von Bläschen oder Ablösungen der Folie vom Glas führen kann.

Abgesehen von der geringeren Verträglichkeit haben Weichmacher geringer Polarität im Vergleich zu stärker polaren Weichmachern wie etwa 3G7 in Kombination mit einem gegebenen PVB die Eigenschaft, zu einer reduzierten Kälteflexibilität der PVB-Folie zu führen. Dies kommt insbesondere zum Tragen, wenn der Weichmachergehalt geringer als 25 Gew.-% eingestellt ist und/oder wenn das verwendete Polyvinylbutyral selber einen geringen Acetalysierungsgrad und damit einen hohen Restgehalt an Polyvinylalkoholgruppen aufweist. Ist nämlich der Acetalysierungsgrad zu gering, resultiert eine erhöhte Erweichungstemperatur (Tg) des PVB, was sich dann negativ auf die Kälteflexibilität der damit hergestellten weichmacherhaltigen Folie auswirkt.

In DE 101 16812 A1 wird zur Weichmachung von PVC und PVB die Verwendung von Derivaten von Cyclohexanpolycarbonsäureestern vorgeschlagen. Hierbei wird eine Mischung mit Polyvinylbutyralen beschrieben, dessen Anteil freier Hydroxygruppen in einem Bereich von 5 bis 50% liegt. In Abhängigkeit von der Art und Verteilung der cyclischen Acetalgruppen, der Hydroxy- und Acetatgruppen weisen diese Polyvinylbutyrale eine Erweichungstemperatur Tg von mindestens 80 °C auf.

Der Gehalt des Polyvinylacetals an der Gesamtmischung wird zwischen 5 und 95 Gew.-%, insbesondere zwischen 20 und 55 Gew.-% angegeben. Bezogen auf den Weichmachergehalt entspricht dies - unter der Vorraussetzung, dass keine weiteren Komponenten zugegen sind - Wertebereichen von 5 - 95 Gew.-% bzw. 45 - 80 Gew.-%.

Unter Verwendung von PVB mit einer Erweichungstemperatur von über 80 °C treten bei höheren Weichmachanteilen Unverträglichkeiten auf. Reduziert man den Weichmacheranteil, so resultiert eine geringere Kälteflexibilität der Folie.

### Technische Aufgabe

Es bestand Bedarf zur Formulierung einer PVB-Folie unter Verwendung eines Weichmachers, welcher zu geringeren Kosten verfügbar ist, in der Folie eine gegenüber 3G8 verringerte Feuchteaufnahme bewirkt und in Kombination mit teilacetalisierten Polyvinylalkoholen ausreichend hohen Acetalysierungsgrades sowohl verträglich ist als auch eine Folie mit guter Kälteflexibilität ergibt.

### Technische Lösung

Es wurde gefunden, dass Folien enthaltend Polyvinylbutyral mit niedriger Erweichungstemperatur (Tg) die mit Diestern der 1,2 Cyclohexandicarbonsäure weich gestellt werden, eine verringerte Feuchteaufnahme gegenüber Folien mit 3G8 als Weichmacher aufweisen. Folien dieser Zusammensetzung haben eine gute Weichmacherverträglichkeit und gute Kälteflexibilität.

### Darstellung der Erfindung

Gegenstand der vorliegenden Erfindung ist daher eine weichmacherhaltige Folie, enthaltend 60 bis 90 % Polyvinylacetal mit einer Erweichungstemperatur Tg von kleiner als 74 °C und 10 bis 40 Gew.% (bezogen auf die Gesamtrezeptur der Folie) mindestens eines Cyclohexandicarbonsäureesters mit 4 bis 17 C-Atomen in der Estergruppe.

Als Cyclohexandicarbonsäureester können alle in DE 101 16 812 aufgeführten Verbindungen eingesetzt werden.

Auf Grund der leichten Zugänglichkeit sind hydrierte Diester der Phthalsäure, d.h. der 1,2 Cyclohexandicarbonsäure bevorzugte Weichmacher der vorliegenden Erfindung.

Als Esteralkohole werden insbesondere solche mit 9 bis 17 Kohlenstoffatomen und besonders bevorzugt solche mit 9, 13 oder 17 Kohlenstoffatomen eingesetzt (sog. Oxoalkohole). Diese Alkohole können verzweigt oder unverzweigt verwendet werden, wobei der Einsatz von weitgehend unverzweigten Esteralkoholen die bessere weichmachende Wirkung erzeugt.

Die erfindungsgemäß verwendeten Cyclohexandicarbonsäureester-Weichmacher können in Kombination mit mindestens einem weiteren apolaren oder polaren, auch als Zusatzweichmacher geeigneten Weichmachern in einem Anteil von 1 bis 40 % eingesetzt werden.

Bevorzugt weisen die Folien einen Gesamtweichmachergehalt d.h. der Anteil aller Weichmacher in der Folie im Bereich von 10 - 40 Gew.%, 14 - 32 Gew.%, 16 - 30 Gew.%, 18 - 28 Gew.%, insbesondere 22 - 26 Gew.% auf. Der Anteil der erfindungsgemäß eingesetzten Cyclohexandicarbonsäureester-Weichmacher kann bezogen auf diese Mischung über 10%, über 20%, über 30%, über 40%, über 50%, über 60%, über 70%, über 80%, oder über 90% liegen.

Grundsätzlich können die Folien Weichmachermischungen aus den genannten Cyclohexandicarbonsäureester-Weichmacher mit mindestens einem der folgenden, für PVB-Folie bekannten Weichmacher enthalten:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyl-adipaten, Heptylnonyl-adipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat.
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten ali-phatischen oder cycloaliphatischen Carbonsäuren; Als Beispiele für letztere Gruppe können dienen Diethylenglykol-bis-(2-ethyl-hexanoat), Triethylenglykol-bis-(2-ethyl-hexanoat), Tri-ethylen-glykol-bis-(2-ethylbu-ta-no-at), Tetra-ethylen-glykol-bis-n-heptanoat, Triethylengly-kol-bis-n-heptanoat, Triethylenglykol-bis-n-hexanoat, Tetraethylen-glykol-dimethyl-ether und/oder Dipropylenglykolbenzoat.

Zur Gruppe geeigneter Zusatzweichmacher mit hoher Polarität zählen zum Beispiel Di-(2-butoxyethyl)-adipat (DBEA), Di-(2-butoxyethyl)-sebacat (DBES), Di-(2-butoxyethyl)-azelat, Di-(2-butoxyethyl)-glutarat. Di-(2-butoxyethoxyethyl)-adipat (DBEEA), Di-(2-butoxy-ethoxyethyl)-sebacat (DBEES), Di-(2-butoxyethoxyethyl)-azelat, Di-(2-butoxyethoxyethyl)-glutarat, Di-(2-hexoxyethyl)-adipat, Di-(2-hexoxyethyl)-sebacat, Di-(2-hexoxyethyl)-azelat, Di-(2-hexoxyethyl)-glutarat, Di-(2-hexoxyethoxyethyl)-adipat, Di-(2-hexoxyethoxyethyl)-sebacat, Di-(2-hexoxyethoxyethyl)-azelat, Di-(2-hexoxyethoxyethyl)-glutarat, Di-(2-butoxyethyl)-phthalat und/oder Di-(2-butoxyethoxyethyl)-phthalat. Ebenso können nichtionische Tenside verwendet werden.

Um die Feuchteresistenz der Folien nicht unnötig durch Verwendung eines zu polaren Weichmachers in der Mischung zu verschlechtern, können insbesondere Weichmacher geringer Polarität mit den erfindungsgemäß verwendeten Cyclohexandicarbonsäureestern kombiniert werden. Als Weichmacher geringer Polarität gelten Weichmacher mit einer gemäß der Formel 100 x (Anzahl O-Atome)/(Anzahl C-Atome + Anzahl H-Atome) berechneten Polarität von kleiner/gleich 9,4. Als Weichmacher geringer Polarität werden bevorzugt Dialkyladipate mit einem Alkylrest mit mehr als 6 Kohlenstoffatomen und Oligoglycolsäureester mit einem Carbonsäurerest mit mehr als 7 Kohlenstoffatomen verwendet. Insbesondere geeignet sind die folgenden Verbindungen:

**Tabelle 1**

| **Name** | **Polaritätswert** |
|---|---|
| Di-2-ethylhexylsebacat (DOS) | 5,3 |
| Di-2-ethylhexyladipat (DOA) | 6,3 |
| Di-2-ethylhexylphthalat (DOP) | 6,5 |
| Triethylenglykol-bis-2-propylhexanoat | 7,9 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |

Zusätzlich können erfindungsgemäße Folien weitere, dem Fachmann bekannte Zusätze enthalten wie Restmengen an Wasser, UV-Absorber, Antioxidantien, Haftungsregulatoren, optische Aufheller, Stabilisatoren, Farbmittel, Verarbeitungshilfs-mittel, organische oder anorganische Nanopartikel, pyrogene Kieselsäure und/oder oberflächen-aktive Stoffe.

Unter Verwendung der genannten Weichmacher bzw. Weichmacherkombinationen ist es möglich, Folien mit besonders geringer Weichmacherabgabe herzustellen, was bei der Weiterverarbeitung den Vorteil reduzierter Geruchsbelästigung bzw. Auftrittswahrscheinlichkeit von Weichmacheraerosolen mit sich bringt und im fertigen VSG den Vorteil erhöhter Langlebigkeit bietet.

Bevorzugt beträgt die Weichmacherabgabe der erfindungsgemäßen Folien (wie im folgenden definiert) weniger als 4 Gew.%, bevorzugt 3 Gew.%, besonders bevorzugt weniger als 2 Gew.% und am meisten bevorzugt weniger als 1 Gew.%, jeweils bezogen auf die Gesamtfolie.

Bevorzugt wird als teilacetalisierter Polyvinylalkohol ein teilacetalisierter bzw. teilbutyralisierter Polyvinylalkohol (Polyvinylbutyral) mit einem Polyvinylacetalgehalt (Acetalisierungsgrad) von gleich oder mehr als 81 Gew.-%, bevorzugt 82, besonders bevorzugt 83, insbesondere 84 Gew.-% eingesetzt, da diese teilacetalisierten Polyvinylalkohole ausreichend niedrige Erweichungstemperaturen und Polaritäten aufweisen und mit den Cyclohexandicarbonsäureester-Weichmachern verträgliche Formulierungen mit guter Kälteflexibilität ergeben. Ein Acetalisierungsgrad von 87 Gew.-% sollte jedoch nicht überschritten werden, da dann die mechanischen Eigenschaften der Folie in der Regel nicht mehr ausreichend sind. In besonders bevorzugten Varianten der Erfindung liegt der Acetalisierungsgrad bei ca. 1 Gew.-% Restacetat bei 81 - 87, 82 - 86 und 83 - 85,5 Gew.-%. Bei höheren Restacetatgehalten oberhalb 1 Gew.-% reduzieren sich die genannten Zahlenwerte für den Acetalysierungsgrad entsprechend.

Die Summe von Acetalysierungsgrad und Restacetat kann als der zu Hundert fehlende Teil aus dem gemäß ASTM D 1396 bestimmten Polyvinylalkoholgehalt, d.h. den Anteil an freien Hydroxylgruppen des Polyvinylacetals berechnet werden. Der Acetalysierungsgrad kann auch durch hochauflösende NMR-Spektroskopie direkt bestimmt werden.

Damit die erfindungsgemäßen Folien eine ausreichende Kälteflexibilität bei einer gleichzeitig auch ausreichenden mechanischen Festigkeit bei erhöhter Temperatur besitzen, weisen die die für die Erfindung verwendbaren Polyvinylacetale grundsätzlich Erweichungstemperaturen (Tg) kleiner/gleich 74 °C, bevorzugt im Bereich 64 - 74 °C, bevorzugt 65 - 73 °C, besonders bevorzugt 66 - 72 °C und insbesondere im Bereich 67 - 71 °C auf.

Zur Herstellung von Polyvinylacetal wird Polyvinylalkohol in Wasser gelöst und mit einem Aldehyd wie Butyraldehyd unter Zusatz eines Säurekatalysators acetalisiert. Das ausgefallene Polyvinylacetals wird abgetrennt, neutral gewaschen, ggf. in einem alkalisch eingestellten wässrigen Medium suspendiert, danach erneut neutral gewaschen und getrocknet.

Der Polyvinylalkoholgehalt des Polyvinylacetals kann durch die Menge des bei der Acetalisierung eingesetzten Aldehyds eingestellt werden. Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. In der Regel liegt der Polyvinylalkohol-Gehalt der eingesetzten teilacetalisierten Polyvinyl-alkohole zwischen 12 und 18 %, bevorzugt zwischen 13 und 16 % und am meisten bevorzugt zwischen 14 und 16 %.

Der Restacetatgehalt der erfindungsgemäß verwendeten Polyvinylacetale liegt in der Regel bei weniger als 5 Gew.-%, bevorzugt weniger als 3 Gew.-%, besonders bevorzugt bei weniger als 2 Gew.-% und insbesondere bei weniger als 1,5 Gew.-% oder 1 Gew.%.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

### Gewerbliche Anwendbarkeit

Die erfindungsgemäßen Folien können insbesondere zur Herstellung von Verbundsicherheitsgläsern durch Laminieren mit einer oder mehreren Glasscheiben in dem Fachmann bekannter Weise verwendet werden. Die Verbundsicherheitsgläser können im Automobilbereich z.B. als Windschutzscheibe, als auch im Architekturbereich als transparente Bauteile oder im Möbelbau verwendet werden. Aufgrund der geringen Feuchteaufnahme und Weichmacherabgabe der erfindungsgemäßen Folien sind diese auch zur Herstellung von Glas/Folie/Kunststoff-Laminaten, wie etwa zur dauerhaften Verklebung einer Glasscheibe mit einer PET-Schicht gut geeignet. Auch das Verkleben zweier Kunststoffscheiben, etwa aus Polycarbonat oder PMMA ist mit den erfindungsgemäßen Folien durchführbar.

Die erfindungsgemäßen Folien können zum Verkleben von Photovoltaikmodulen verwendet werden.

Ein weiterer Gegenstand der vorliegenden Erfindung sind daher Photovoltaikmodule, umfassend ein Laminat aus
a) einer transparenten Frontabdeckung
b) einer oder mehreren photosensitiven Halbleiterschichten
c) mindestens eine weichmacherhaltige, auf Polyvinylacetal basierenden Folie und
d) einer rückwärtigen Abdeckung
wobei die weichmacherhaltige Folie 60 bis 90 % Polyvinylacetal mit einer Erweichungstemperatur Tg von kleiner als 74 °C und 10 bis 40 Gew.% mindestens eines Cyclohexandicarbonsäureesters mit 4 bis 17 C-Atomen in der Estergruppe als Weichmacher enthält.

Für die erfindungsgemäßen Photovoltaikmodule können alle beschriebenen Varianten der weichmacherhaltigen Folie bzw. der beschriebenen Varianten des Cyclohexandicarbonsäureesters eingesetzt werden.

Bevorzugt weisen die erfindungsgemäß eingesetzten Folien bei einer Umgebungsfeuchte von 85% rF bei 23°C einen spezifischen Widerstand von mindestens 5E+11 ohm*cm oder mindestens 1E+12 ohm*cm, besonders bevorzugt mindestens 5E+12 ohm*cm oder mindestens 1 E+13 ohm*cm oder insbesondere mindestens 1 E+14 ohm*cm auf. Diese Werte sollten an jeder Stelle der Folie erreicht werden, insbesondere im Randbereich des Moduls.

Weiterhin kann die möglicherweise vom Wassergehalt der Folie abhängende Ionenbeweglichkeit und damit der spezifische Widerstand durch den Zusatz von SiO₂, insbesondere pyrogener Kieselsäure beeinflusst werden. Bevorzugt enthalten die erfindungsgemäß verwendeten weichmacherhaltigen, auf Polyvinylacetal basierenden Folien 0.001 bis 15 Gew.%, bevorzugt 2 bis 5 Gew.% SiO₂.

Die Vermeidung von Säurespuren bei der Herstellung des Folienmaterials ist eine Möglichkeit, die Korrosionsneigung der erfindungsgemäß eingesetzten Folien gegenüber photosensitiven Halbleiterschichten zu verringern. Folien dieser Art werden in der Regel durch Extrusion der weichmacherhaltige Polyvinylacetale unter erhöhten Temperaturen hergestellt, wodurch eine thermische Zersetzung des polymeren Materials bzw. des Weichmachers auftreten kann. Weiterhin kann durch eindiffundiertes Wasser eine Spaltung der Restacetatgruppen des Polyvinylalkohols auftreten, wodurch Essigsäure freigesetzt wird. In beiden Fällen resultieren Säurespuren, die die photosensitiven Halbleiterschichten angreifen können.

Bevorzugt weisen die erfindungsgemäß eingesetzten Folien daher eine gewisse Basizität, ausgedrückt als Alkali-Titer auf, der über 5 oder 10, bevorzugt über 15 und insbesondere über 20, 30 oder 40 liegen sollte. Ein maximaler Alkali-Titer von 100 sollte nicht überschritten werden.

Der Alkali-Titer wird, wie im folgenden beschrieben, durch Rücktitration der Folie bestimmt und kann durch Zugabe von basischen Substanzen, wie z.B. Metallsalze von organischen Carbonsäuren mit 1 bis 15 Kohlenstoffatomen, insbesondere Alkali- oder Erdalkalisalze wie Magnesium- oder Kaliumacetat eingestellt werden. Die basische Verbindung wird üblicherweise in einer Konzentration von 0,005 bis 2 Gew.% insbesondere 0,05 bis 1 Gew.%, bezogen auf die gesamte Mischung eingesetzt.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

In einer Variante der erfindungsgemäßen Photovoltaikmodule werden die photosensitiven Halbleiterschichten auf die Abdeckung d) aufgebracht (z.B. durch Aufdampfen, Gasphasenabscheidung, Sputtern oder Nassabscheidung) und durch eine Folie c) mit der transparenten Frontabdeckung a) verklebt.

In einer anderen Variante werden die photosensitiven Halbleiterschichten auf die transparente Frontabdeckung a) aufgebracht und durch die Folie c) mit der rückwärtigen Abdeckung d) verklebt.

Alternativ können die photosensitiven Halbleiterschichten zwischen zwei Folien c) eingebettet und so mit den Abdeckungen a) und d) verklebt werden.

Die Dicke der auf weichmacherhaltigem Polyvinylacetal basierenden Folien liegt in der Verwendung für Photovoltaik-Module üblicherweise bei 0.38, 0.51, 0.76, 1.14, 1.52 oder 2.28 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung a) besteht in der Regel aus Glas oder PMMA. Die rückwärtige Abdeckung d) (sog. Backsheet) des erfindungsgemäßen Photovoltaikmoduls kann aus Glas, Kunststoff oder Metall oder deren Verbünden bestehen, wobei einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolier-verglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Bei Dünnschicht-Solarmodulen ist die photosensitive Halbleiterschicht direkt auf einen Träger aufgebracht. Eine Einkapselung ist hier nicht möglich. Daher wird der Schichtkörper aus einem Träger (z.B. der rückwärtigen Abdeckung) mit der photosensitiven Halbleiterschicht und der transparenten Frontabdeckung durch mindestens eine zwischen gelegte, auf weichmacherhaltigem Polyvinylacetal basierende erfindungsgemäße Folie zusammengelegt und durch diese bei erhöhter Temperatur verklebt. Alternativ kann die photosensitive Halbleiterschicht auf die transparente Frontabdeckung als Träger aufgebracht und mit der der rückwärtigen Abdeckung durch mindestens eine zwischen gelegte, auf weichmacherhaltigem Polyvinylacetal basierende erfindungsgemäße Folie verklebt sein.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumring-verfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbund-verglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

### Messmethoden

Zur Bestimmung des Alkali-Titers werden 3 bis 4 gr. des weichmacherhaltigen Polyvinylacetal-Films in 100 ml einer Mischung von Ethanol/THF (80:20) in einem Magnetrührer über Nacht gelöst. Hierzu werden 10 ml einer verdünnten Salzsäure (c=0,01 mol/Liter) gegeben und anschließend potentiometrisch mit einer Lösung von Tetrabutylammoniumhydroxid (TBAH) in 2-Propanol (c=0,01 mol/Liter) mit einem Titroprozessor gegen eine Leerprobe potentiometrisch titriert. Der Alkali-Titer berechnet sich wie folgt:

Alkali-Titer = ml HCl pro 100 gr einer Probe = (Verbrauch TBAH Leerprobe - TBAH Probe x 100 durch Gewicht der Probe in gr.)

Die Messung des spezifischen Durchgangswiderstandes der Folie erfolgt gemäß DIN IEC 60093 bei definierter Temperatur und Umgebungsfeuchte (23 °C und 85% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit Rz bei Messung nach DIN EN ISO 4287 nicht größer als 10 mm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspekroskopie (AAS).

Zur Bestimmung des Ausschwitzverhaltens einer PVB-Folie bei hoher Feuchte wird ein Teststreifen in einer mit Wasserdampf gesättigten Atmosphäre für 30 Tage gelagert. Durch die Aufnahme von Wasser und der damit einher gehenden Zunahme der Polarität, lässt sich bei wenig verträglichen Systemen der Weichmacher verdrängen, so dass dieser mit der Zeit an der Oberfläche der Folie als gut sichtbarer Film oder in Tropfenform austritt. Bei verträglichen Formulierungen kann an Teststreifen nach 30 Tagen kein Weichmacheraustritt festgestellt werden, wogegen dies bei unverträglichen Formulierungen häufig schon nach 24 h der Fall ist. Zur Einstellung einer Atmosphäre mit hoher relativer Luftfeuchtigkeit (rF) wird in einem geschlossenen Gefäß, wie z.B. einem Glasexsiccator, eine gesättigte wässrige Lösung aus Kupfersulfatpentahydrat mit einem Bodensatz hergestellt. Über dieser Lösung stellt sich bei 23 °C eine Gleichgewichtsfeuchte von ca. 98 % rF ein.

Zur Bestimmung des Ausschwitzverhaltens einer PVB-Folie in kalter Umgebung wird ein Folienabschnitt der Abmessung 30 x 10 cm zunächst während 24 h in einem Klima von 23 °C / 23 rF konditioniert und anschließend zu einer Rolle aufgewickelt in einen wasserdampfdichten Alu-PE Beutel eingeschweißt 1 Woche lang bei einer Temperatur von 5 °C gelagert. Nach Ablauf der Woche wird die Folie entnommen und auf ausgetreten Weichmacher hin untersucht.

Für die Herstellung von weichgemachten PVB-Folien zur Überprüfung ihres Ausschwitzverhaltens kann die Folienmasse z.B. auf einem Walzenstuhl oder durch Extrusion homogenisiert werden.

Die Weichmacherabgabe aus der PVB-Folie wird experimentell unter Bedingungen ermittelt, welche an eine Prozessführung im Vakuumlaminator, wie er zur Herstellung von Photovoltaikmodulen verwendet wird, angelehnt sind. Hierzu wird aus einer 0.76 mm dicken Folie / Muster eine Ronde in mit einem Durchmesser von 60 mm ausgeschnitten bzw. hergestellt und flach auf den Boden in eine tarierte Aluschale mit einem Durchmesser von 65 mm (neoLab-Aluschale, glatt, 65 mm, Art.-Nr. 2-1605, Gewicht ca. 2,5 g) eingelegt. Die Probe wird in der Schale über Nacht in einem Klima von 23 °C / 25% rF konditioniert und anschließend während 30 Minuten bei 150 °C und 1 mbar in einen Vakuumtrockenschrank (Heraeus, Modell VTR 5022) belassen. Vor dem Zurückwiegen wird die Schale erneut über Nacht bei 23 °C / 25% rF konditioniert. Die festgestellte Gewichtsabnahme bezogen auf die Originaleinwaage der Folie in Prozent wird als Weichmacherabgabe definiert.

Die Bestimmung der Erweichungstemperatur Tg des teilacetalisierten Polyvinylalkohols erfolgt mittels Dynamischer Differenzkalorimetrie (DSC) gemäß DIN 53765 unter Verwendung einer Heizrate von 10K/min im Temperaturintervall -50 °C - 150°C. Es wird eine erste Heizrampe, gefolgt von einer Kühlrampe, gefolgt von einer zweiten Heizrampe gefahren. Die Lage der Glasübergangstemperatur wird an der der zweiten Heizrampe zugehörigen Messkurve nach DIN 51007 ermittelt. Der DIN-Mittelpunkt (Tg DIN) ist definiert als Schnittpunkt einer Horizontalen auf halber Stufenhöhe mit der Messkurve. Die Stufenhöhe ist durch den vertikalen Abstand der beiden Schnittpunkte der Mitteltangente mit den Basislinien der Messkurve vor und nach Glasumwandlung definiert.

Der Wasser- bzw. Feuchtegehalt der Folien wird mit der Karl-Fischer-Methode bestimmt, nachdem die Folie bei 23 °C und 85% rF wenigstens 24h konditioniert wurde.

Die Kälteflexibilität der Folien wird auf einfache Weise durch manuellen Vergleich von DIN A4 großen Folienabschnitten bei einer Lagertemperatur von 5 °C bewertet.

### Beispiele

Die erfindungsgemäßen Folien der Beispiele erfüllen die Anforderungen, die üblicherweise an PVB-Folie für Verbundsicherheitsglas oder Photovoltaikmodule gestellt werden, das sind im einzelnen: hohe Transparenz bzw. Abwesenheit von Trübung, geringe Eigenfarbe und hier insbesondere niedriger Gelbwert, ausreichende mechanische Festigkeit, geringer Eigengeruch, Möglichkeit der Haftungsreduktion bei Zugabe der üblichen Antihaftmittel, gute und gleichmäßige Klebewirkung zu Glas und hoher Durchgangswiderstand.

Es wurden Folien gemäß den Zusammensetzungen der Tabellen 2 bis 4 hergestellt und auf ihre Eignung in Verbundsicherheitsglas oder Photovoltaikmodule geprüft. Soweit nicht anders angegeben sind alle Angaben in Gew.-% bezogen auf die Gesamtfolie, Ausnahme: PVOH-Gehalt, auf die Menge des PVB-Harzes bezogen. Hexamoll DINCH steht für Di-isononylcyclohexan-1,2-dicarbonsäure der BASF SE, AEROSIL 130 ist ein Handelsprodukt der Evonik Degussa GmbH.

Anhand von Vergleichsbeispiel 1 wurde verifiziert, dass ein Polyvinylbutyral mit einem Acetalysierungsgrad von 79 Gew.-%, einem PVA-Gehalt von 20,0 Gew.-% und einer Erweichungstemperatur von 75 °C bei einem für PVB-Folie typischen Mischungsverhältnis (74 Gew.-% PVB, 26 Gew.-% DINCH) sowohl in feuchter Atmosphäre (nach 30 Tagen) bzw. in kalter Umgebung (nach 1 Woche) das DINCH teilweise wieder abgegeben hat, also Ausschwitzen zeigt. Zusätzlich hat eine solche Folie nur eine mittlere Kälteflexibilität.

Vergleichsbeispiel 8 zeigt, dass ein Polyvinylbutyral mit einem Acetalysierungsgrad von 72,5 Gew.-%, einem PVA-Gehalt von 26,4 Gew.-% und einer Erweichungstemperatur von 81 °C selbst bei Verwendung einer relativ geringen Menge DINCH als Weichmacher (80 Gew.-% PVB, 20 Gew.-% DINCH) letzteren sowohl in feuchter Atmosphäre (nach 30 Tagen) bzw. in kalter Umgebung (nach 1 Woche) teilweise wieder abgibt, also Ausschwitzen zeigt. Zusätzlich weist eine solche Folie eine schlechte Kälteflexibilität auf.

Ein Vergleich der erfindungsgemäßen Beispiele 2 und 4 mit den nichterfindungsgemäßen Vergleichs-Beispielen 3 und 5 zeigt, dass sich sowohl die Feuchteaufnahme als auch die Weichmacherabgabe bei Verwendung von DINCH gegenüber den mit 3G8 hergestellten Versuchsfolien weiter reduzieren lässt.

Erfindungsgemäßes Beispiel 6 belegt, dass bei Verwendung eines Polyvinylbutyrals mit einem Acetalysierungsgrad von 86 Gew.-%, einem PVA-Gehalt von 13,0 Gew.-% und einer Erweichungstemperatur von 67 °C in Mischung mit 26 Gew.-% Hexamoll DINCH eine Folie mit ausreichender Verträglichkeit resultiert, welche eine besonders geringe Feuchteaufnahme und niedrige Weichmacherabgabe aufweist.

Erfindungsgemäßes Beispiel 7 belegt, dass bei Verwendung eines Polyvinylbutyrals mit einem Acetalysierungsgrad von 84,7 Gew.-%, einem PVA-Gehalt von 14,3 Gew.-% und einer Erweichungstemperatur von 68 °C in Mischung mit 24 Gew.-% Hexamoll DINCH bei Verwendung von Magnesiumacetat-Tetrahydrat ein erhöhter Alkalititer einstellen lässt, ohne den elektrischen Durchgangswiderstand zu verschlechtern und ohne dass die beschriebenen Merkmale der ausreichenden Verträglichkeit besonders geringer Feuchteaufnahme und Weichmacherabgabe beeinflusst werden.

Erfindungsgemäßes Beispiel 8 belegt, dass bei Verwendung eines Polyvinylbutyrals mit einem Acetalysierungsgrad von 84,7 Gew.-%, einem PVA-Gehalt von 14,3 Gew.-% und einer Erweichungstemperatur von 68 °C in Mischung mit 24 Gew.-% Hexamoll DINCH, durch Zusatz von pyrogenem SiO₂ und Verwendung von Magnesiumacetat-Tetrahydrat ein erhöhter Alkalititer einstellen lässt und gleichzeitig der elektrische Durchgangswiderstand weiter erhöhen lässt, ohne dass die beschriebenen Merkmale der ausreichenden Verträglichkeit besonders geringer Feuchteaufnahme und Weichmacherabgabe nennenswert beeinflusst werden.

Erfindungsgemäßes Beispiel 9 belegt, dass bei Verwendung eines Polyvinylbutyrals mit einem Acetalysierungsgrad von 84,7 Gew.-%, einem PVA-Gehalt von 14,3 Gew.-% und einer Erweichungstemperatur von 68 °C in Mischung mit 24 Gew.-% Hexamoll DINCH, durch Zusatz von pyrogenem SiO₂ der elektrische Durchgangswiderstand weiter erhöhen lässt, ohne dass die beschriebenen Merkmale der ausreichenden Verträglichkeit besonders geringer Feuchteaufnahme und Weichmacherabgabe nennenswert beeinflusst werden.

Erfindungsgemäße Folien sind aufgrund ihrer guten Isolationseigenschaften gut zur Herstellung von Photovoltaikmodulen geeignet. Zusätzlich weisen die Folien der erfindungsgemäßen Beispiele 7 bis 9 aufgrund ihrer erhöhten Alkalinität und/oder der Anwesenheit von pyrogenem SiO₂ eine besonders geringe Korrosivität gegenüber den empfindlichen Funktionsschichten von Photovoltaikmodulen auf.

**Tabelle 2**

| **Beispiel Nr.:** | **V1** | **E2** | **V3** | **E4** |
|---|---|---|---|---|
| Polyvinylbutyral | 76 | 76 | 76 | 78 |
| Acetalysierungsgrad des PVB | 79,0 | 84,7 | 84,7 | 82,8 |
| PVA-Gehalt des PVB | 20,0 | 14,3 | 14,3 | 16,2 |
| Erweichungstemperatur (Tg) des PVB in °C | 75 | 68 | 68 | 71 |
| Hexamoll DINCH | 24 | 24 | - | 22 |
| 3G8 | - | - | 24 | - |
| Weichmacherausschwitzen bei hoher Feuchte nach 30 Tagen | Ja | Nein | Nein | Nein |
| Weichmacherausschwitzen bei 5 °C nach einer Woche | Ja | Nein | Nein | Nein |
| Gleichgewichtsfeuchte bei | - | 1,6 | 1,8 | 1,8 |
| 23 °C / 85% rF in Gew.-% | | | | |
| Weichmacherabgabe in % | 2,0 | 0,7 | 1,5 | 1,2 |
| Elektrischer Durchgangswiderstand bei 23°C / 85% rF in Ohm x cm | - | 3,0 x E14 | 2,7 x E12 | 5,8 x E13 |
| Kälteflexibilität | mittel | gut | gut | gut |

**Tabelle 3**

| **Beispiel Nr.:** | **V5** | **E6** | **V7** | **V8** |
|---|---|---|---|---|
| Polyvinylbutyral | 78 | 74 | 73 | 80 |
| Acetalysierungsgrad des PVB | 82, 8 | 86, 0 | 78,4 | 72,5 |
| PVA-Gehalt des PVB | 16, 2 | 13, 0 | 20,5 | 26,4 |
| Erweichungstemperatur (Tg) des PVB in °C | 71 | 67 | 78 | 81 |
| Hexamoll DINCH | - | 26 | - | 20 |
| 3G8 | 22 | - | 27 | - |
| Weichmacherausschwitzen bei hoher Feuchte nach 30 Tagen | Nei n | Nei n | Ja | Ja |
| Weichmacherausschwitzen bei 5 °C nach einer Woche | Nei n | Nei n | Ja | Ja |
| Gleichgewichtsfeuchte bei 23 °C / 85% rF in Gew.-% | 2,1 | 1,4 | 2,7 | - |
| Weichmacherabgabe in % | 1,8 | 0,8 | 4,1 | - |
| Kälteflexibilität | gut | gut | mittel | schlecht |

**Tabelle 4**

| **Beispiel Nr.:** | **E7** | **E8** | **E9** |
|---|---|---|---|
| Polyvinylbutyral | 76 | 76 | 76 |
| Acetalysierungsgrad des PVB | 84,7 | 84,7 | 84,7 |
| PVA-Gehalt des PVB | 14,3 | 14,3 | 14,3 |
| Erweichungstemperatur (Tg) des PVB in °C | 68 | 68 | 68 |
| Hexamoll DINCH | 24 | 24 | 24 |
| Magnesiumacetat tetrahydrat | 0,015 | 0,050 | - |
| Aerosil 130 | - | 1,5 | 1,5 |
| Weichmacherausschwitzen bei hoher Feuchte nach 30 Tagen | Nein | Nein | Nein |
| Weichmacherausschwitzen bei 5 °C nach einer Woche | Nein | Nein | Nein |
| Gleichgewichtsfeuchte bei 23 °C / 85% rF in Gew.-% | 1,6 | 1,7 | 1,7 |
| Weichmacherabgabe in % | 0,7 | 0,6 | 0,6 |
| Kälteflexibilität | gut | gut | gut |
| Alkali-Titer | 9 | 40 | 3 |
| Elektrischer Durchgangswiderstand bei 23°C / 85% rF in Ohm x cm | 3,2 x E14 | > 3,5 x E14 | > 3,5 x E14 |

## Patentansprüche

1. Weichmacherhaltige Folie enthaltend 60 bis 90 % Polyvinylacetal mit einer Erweichungstemperatur Tg gemäß DIN 53765 von kleiner als 74 °C und 10 bis 40 Gew.% mindestens eines Cyclohexandicarbonsäureesters mit 4 bis 17 C-Atomen in der Estergruppe als Weichmacher.

2. Weichmacherhaltige Folie nach Anspruch 1, **dadurch gekennzeichnet, dass** die Folie zusätzlich 1 bis 40 Gew.% mindestens eines weiteren Weichmachers enthält.

3. Weichmacherhaltige Folie nach Anspruch 1 oder 2, **dadurch gekennzeichnet, dass** die Folie zusätzlich 1 bis 40 Gew.% mindestens eines Weichmachers mit hoher Polarität, ausgewählt aus der Gruppe Di-(2-butoxyethyl)-adipat (DBEA), Di-(2-butoxyethyl)-sebacat (DBES), Di-(2-butoxyethyl)-azelat, Di-(2-butoxyethyl)-glutarat. Di-(2-butoxyethoxyethyl)-adipat (DBEEA), Di-(2-butoxy-ethoxyethyl)-sebacat (DBEES), Di-(2-butoxyethoxyethyl)-azelat, Di-(2-butoxyethoxyethyl)-glutarat, Di-(2-hexoxyethyl)-adipat, Di-(2-hexoxyethyl)-sebacat, Di-(2-hexoxyethyl)-azelat, Di-(2-hexoxyethyl)-glutarat, Di-(2-hexoxyethoxyethyl)-adipat, Di-(2-hexoxyethoxyethyl)-sebacat, Di-(2-hexoxyethoxyethyl)-azelat, Di-(2-hexoxyethoxyethyl)-glutarat, Di-(2-butoxyethyl)-phthalat und Di-(2-butoxyethoxyethyl)-phthalat enthält.

4. Weichmacherhaltige Folie nach einem der Ansprüche 1 bis 3, **dadurch gekennzeichnet, dass** die Folie zusätzlich 1 bis 40 Gew.% mindestens einer Verbindung mit einer gemäß der Formel 100 x (Anzahl O-Atome)/(Anzahl C-Atome + Anzahl H-Atome) berechneten Polarität von kleiner/gleich 9,4. als Weichmacher enthält.

5. Weichmacherhaltige Folie nach einem der Ansprüche 1 bis 4, **dadurch gekennzeichnet, dass** der Acetalisierungsgrad des Polyvinylacetats größer gleich 81 Gew.% ist.

6. Weichmacherhaltige Folie nach einem der Ansprüche 1 bis 5, **dadurch gekennzeichnet, dass** der Acetatgehalt des Polyvinylacetals weniger als 5 Gew.% beträgt.

7. Weichmacherhaltige Folie nach einem der Ansprüche 1 bis 6, **dadurch gekennzeichnet, dass** die Folie eine Weichmacherabgabe von weniger als 4 Gew.% aufweist.

8. Weichmacherhaltige Folie nach einem der Ansprüche 1 bis 7, **dadurch gekennzeichnet, dass** als Polyvinylacetal Polyvinylbutyral eingesetzt wird.

9. Verwendung der weichmacherhaltigen Folie nach einem der Ansprüche 1 bis 8 zur Herstellung von Verbundsicherheitsgläsern und zum Verkleben von Photovoltaikmodulen.

10. Photovoltaikmodul , umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung **dadurch gekennzeichnet, dass** die weichmacherhaltige Folie 60 bis 90 % Polyvinylacetal mit einer Erweichungstemperatur Tg gemäß DIN 53765 von kleiner als 74 °C und 10 bis 40 Gew.% mindestens eines Cyclohexandicarbonsäureesters mit 4 bis 17 C-Atomen in der Estergruppe als Weichmacher enthält.

11. Photovoltaikmodul nach Anspruch 10 **dadurch gekennzeichnet, dass** die weichmacherhaltigen auf Polyvinylacetal basierenden Folien c) ein Metallsalz einer Carbonsäure mit 1 bis 15 Kohlenstoffatomen als basische Verbindung enthalten.

12. Photovoltaikmodul nach einem der Ansprüche 10 oder 11, **dadurch gekennzeichnet, dass** die weichmacherhaltige, auf Polyvinylacetal basierende Folie 0.001 bis 5 Gew.% SiO₂ enthält.

13. Photovoltaikmodul nach einem der Ansprüche 10 bis 12 **dadurch gekennzeichnet, dass** eine oder mehrere photosensitive Halbleiterschichten b) auf eine transparente Frontabdeckung a) oder eine rückwärtige Abdeckung d) aufgebracht werden und durch mindestens eine weichmacherhaltige, auf Polyvinylacetal basierende Folie c) miteinander verklebt sind.

14. Photovoltaikmodul nach einem der Ansprüche 10 bis 12 **dadurch gekennzeichnet, dass** die photosensitiven Halbleiterschichten b) zwischen zwei Folien c) eingebettet und mit den Abdeckungen a) und d) verklebt werden.

## Claims

1. A plasticiser-containing film containing 60 to 90 % of polyvinyl acetal with a softening point Tg in accordance with DIN 53765 of less than 74 °C and 10 to 40 % by weight of at least one cyclohexane dicarboxylic acid ester containing 4 to 17 C atoms in the ester group as a plasticiser.

2. The plasticiser-containing film according to Claim 1, **characterised in that** the film additionally contains 1 to 40 % by weight of at least one further plasticiser.

3. The plasticiser-containing film according to Claim 1 or 2, **characterised in that** the film additionally contains 1 to 40 % by weight of at least one plasticiser of high polarity, selected from the group of di(2-butoxyethyl) adipate (DBEA), di(2-butoxyethyl) sebacate (DBES), di(2-butoxyethyl) azelate, di(2-butoxyethyl) glutarate, di(2-butoxyethoxyethyl) adipate (DBEEA), di(2-butoxethoxyyethyl) sebacate (DBEES), di(2-butoxyethoxyethyl) azelate, di(2-butoxyethoxyethyl) glutarate, di(2-hexoxyethyl) adipate, di(2-hexoxyethyl) sebacate, di(2-hexoxyethyl) azelate, di(2-hexoxyethyl) glutarate, di(2-hexoxyethoxyethyl) adipate, di(2-hexoxyethoxyethyl) sebacate, di(2-hexoxyethoxyethyl) azelate, di(2-hexoxyethoxyethyl) glutarate, di(2-butoxyethyl) phthalate and di(2-butoxyethoxyethyl) phthalate.

4. The plasticiser-containing film according to one of Claims 1 to 3, **characterised in that** the film additionally contains 1 to 40 % by weight of at least one compound having a polarity, calculated in accordance with the formula 100 x (number of O atoms)/(number of C atoms + number of H atoms), of less than or equal to 9.4 as a plasticiser.

5. The plasticiser-containing film according to one of Claims 1 to 4, **characterised in that** the degree of acetalisation of the polyvinyl acetate is greater than or equal to 81 % by weight.

6. The plasticiser-containing film according to one of Claims 1 to 5, **characterised in that** the acetate content of the polyvinyl acetal is less than 5 % by weight.

7. The plasticiser-containing film according to one of Claims 1 to 6, **characterised in that** the film has a plasticiser discharge of less than 4 % by weight.

8. The plasticiser-containing film according to one of Claims 1 to 7, **characterised in that** polyvinyl butyral is used as a polyvinyl acetal.

9. Use of the plasticiser-containing film according to one of Claims 1 to 8 for producing laminated safety glazings and for bonding photovoltaic modules.

10. A photovoltaic module, comprising a laminate formed from
a) a transparent front covering
b) one or more photosensitive semiconductor layers
c) at least one plasticiser-containing film based on polyvinyl acetal, and
d) a rear covering, **characterised in that** the plasticiser-containing film contains 60 to 90 % of polyvinyl acetal with a softening point Tg in accordance with DIN 53765 of less than 74 °C and 10 to 40 % by weight of at least one cyclohexane dicarboxylic acid ester containing 4 to 17 C atoms in the ester group as a plasticiser.

11. The photovoltaic module according to claim 10, **characterised in that** the plasticiser-containing films c) based on polyvinyl acetal contain a metal salt of a carboxylic acid containing 1 to 15 carbon atoms as a basic compound.

12. The photovoltaic module according to one of Claims 10 or 11, **characterised in that** the plasticiser-containing film based on polyvinyl acetal contains 0.001 to 5 % by weight of SiO₂.

13. The photovoltaic module according to one of Claims 10 to 12, **characterised in that** one or more photosensitive semiconductor layers b) is/are applied to a transparent front covering a) or to a rear covering d) and is/are bonded together by at least one plasticiser-containing film based on polyvinyl acetal c).

14. The photovoltaic module according to one of Claims 10 to 12, **characterised in that** the photosensitive semiconductor layers b) are embedded between two films c) and are bonded to the coverings a) and d).

## Revendications

1. Film contenant un plastifiant, contenant de 60 à 90 % d'acétal de polyvinyle avec une température de ramollissement Tg selon la norme DIN 53765 inférieure à 74 °C et de 10 à 40 % en poids d' au moins un ester d' acide cyclohexane dicarboxylique avec de 4 à 17 atomes de carbone dans le groupe ester en tant que plastifiant.

2. Film contenant un plastifiant selon la revendication 1, **caractérisé en ce que** le film contient en supplément de 1 à 40 % en poids d'au moins un plastifiant supplémentaire.

3. Film contenant un plastifiant selon la revendication 1 ou la revendication 2, **caractérisé en ce que** le film contient en supplément de 1 à 40 % en poids d'un plastifiant à polarité élevée, choisi dans le groupe comprenant l'adipate de di-(2-butoxyéthyle) (DBEA), le sébaçate de di-(2-butoxyéthyle) (DBES), l'azélate de di-(2-butoxyéthyle), le glutarate de di-(2-butoxyéthyle), l'adipate de di-(2-butoxyéthoxyéthyle) (DBEEA), le sébaçate de di-(2-butoxyéthoxyéthyle) (DBEES), l'azélate de di-(2-butoxyéthoxyéthyle), le glutarate de di-(2-butoxyéthoxyéthyle), l'adipate de di-(2-hexoxyéthyle), le sébaçate de di-(2-hexoxyéthyle), l'azélate de di-(2-hexoxyéthyle), le glutarate de di-(2-hexoxyéthyle), l'adipate de di-(2-hexoxyéthoxyéthyle), le sébaçate de di-(2-hexoxyéthoxyéthyle), l'azélate de di-(2-hexoxyéthoxyéthyle), le glutarate de di-(2-hexoxyéthoxyéthyle), le phtalate de di-(2-butoxyéthyle) et le phtalate de di-(2-butoxyéthoxyéthyle).

4. Film contenant un plastifiant selon l'une quelconque des revendications 1 à 3, **caractérisé en ce que** le film contient en supplément de 1 à 40 % en poids d'au moins un composé d'une polarité calculée selon la formule 100 x (nombre d'atomes O)/(nombre d'atomes C + nombre d'atomes H) inférieure/égale à 9,4 en tant que plastifiant.

5. Film contenant un plastifiant selon l'une quelconque des revendications 1 à 4, **caractérisé en ce que** le degré d'acétylisation de l'acétal de polyvinyle est supérieur ou égal à 81 % en poids.

6. Film contenant un plastifiant selon l'une quelconque des revendications 1 à 5, **caractérisé en ce que** la teneur en acétate de l'acétal de polyvinyle est inférieure à 5 % en poids.

7. Film contenant un plastifiant selon l'une quelconque des revendications 1 à 6, **caractérisé en ce que** le film fait preuve d'un dégagement de plastifiant inférieur à 4 % en poids.

8. Film contenant un plastifiant selon l'une quelconque des revendications 1 à 7, **caractérisé en ce qu'**en tant qu'acétal de polyvinyle, on utilise du butyral de polyvinyle.

9. Utilisation du film contenant un plastifiant selon l'une quelconque des revendications 1 à 8 pour la fabrication de verres de sécurité composites et pour le collage de modules photovoltaïques.

10. Module photovoltaïque, comprenant un laminé
a) d'un recouvrement frontal transparent
b) d'une ou de plusieurs couche(s) photosensible(s) de semi-conducteurs
c) d'au moins un film contenant un plastifiant, basé sur de l'acétal de polyvinyle et
d) d'un recouvrement arrière, **caractérisé en ce que** le film contenant un plastifiant, contient de 60 à 90 % d' acétal de polyvinyle avec une température de ramollissement Tg selon la norme DIN 53765 inférieure à 74°C et de 10 à 40 % en poids d'au moins un ester d'acide cyclohexane dicarboxylique avec de 4 à 17 atomes de carbone dans le groupe ester en tant que plastifiant.

11. Module photovoltaïque selon la revendication 10, **caractérisé en ce que** .ce que les films c) contenant un plastifiant, basés sur de l'acétal de polyvinyle contiennent un sel métallique d'un acide carboxylique avec de 1 à 15 atomes de carbone, en tant que composé basique.

12. Module photovoltaïque selon l'une quelconque des revendications 10 ou 11, **caractérisé en ce que** le film contenant un plastifiant, basé sur de l'acétal de polyvinyle contient de 0.001 à 5 % en poids de SiO₂.

13. Module photovoltaïque selon l'une quelconque des revendications 1 à 5, **caractérisé en ce qu'** on applique une ou plusieurs couches photosensibles de semi-conducteurs b) sur un recouvrement frontal a) transparent ou sur un recouvrement arrière d) et **en ce qu'** ils sont collés l'un à l' autre par au moins un film c) contenant un plastifiant basé sur de l'acétal de polyvinyle sur le recouvrement frontal a) transparent.

14. Module photovoltaïque selon l'une quelconque des revendications 1 à 5, **caractérisé en ce qu'**on noie une ou plusieurs couches photosensibles de semi-conducteurs (b) entre deux films c) et on les colle avec les recouvrements a) et d).
